# EUROPÄISCHE PATENTSCHRIFT

(11) **EP 2 171 542 B1**
(45) Veröffentlichungstag und Bekanntmachung des Hinweises auf die Patenterteilung: **24.08.2011**
(21) Anmeldenummer: 08758183.1
(22) Anmeldetag: 09.06.2008
(51) Int. Cl.: G03F 7/34

(54) **VERFAHREN UND VORRICHTUNG ZUR HERSTELLUNG VON STRUKTURIERTEN OPTISCHEN MATERIALIEN**
METHOD AND DEVICE FOR PRODUCING STRUCTURED OPTICAL MATERIALS
PROCÉDÉ ET DISPOSITIF DE FABRICATION DE MATÉRIAUX OPTIQUES STRUCTURÉS

(30) Priorität: 26.07.2007 DE 102007035387
(43) Veröffentlichungstag der Anmeldung: 07.04.2010
(73) Patentinhaber: Leibniz-Institut für Neue Materialien gemeinnützige GmbH, 66123 Saarbrücken (DE)
(72) Erfinder: OLIVEIRA, Peter, W., 66111 Saarbrücken (DE); ROGIN, Peter, 66113 Saarbrücken (DE); GROS, Michael, 66440 Blieskastel (DE); AMLUNG, Martin, 66132 Saarbrücken (DE); VEITH, Michael, 66386 St. Ingbert (DE)
(74) Vertreter: Vièl, Christof
(86) Internationale Anmeldenummer: PCT/DE2008/000970
(87) Internationale Veröffentlichungsnummer: WO 2009/012738

(56) Entgegenhaltungen:
- EP-A- 0 726 142
- EP-A- 1 239 329
- WO-A-96/30810

## Beschreibung

Die Erfindung betrifft ein Verfahren zur Herstellung von strukturierten optischen Materialien,. Sie betrifft auch eine Vorrichtung zur Herstellung von strukturierten optischen Materialien und die Verwendung des Verfahrens.

Lithographische Masken auf Folienbasis werden in der EP 168 924 A2, der EP 323 880 A1 und der DE 689 16 188 T2 beschrieben. Großer Nachteil der Folienmaske ist, daß sie nur einmal benutzt werden kann und eines großen Herstellungsaufwandes bedarf.

Die Herstellung von Diffuseren bzw. Lichtmanagementfolien zur Lichtlenkung (für TFTs, Projektoren, Displays, etc.) erfolgte gemäß dem Stand der Technik beispielsweise mit einer derartigen Folienmaske zur UV-Strukturierung mit einer modifizierten Folienbeschichtungsanlage der Firma Mathis. Hierfür wurde zunächst eine Polyesterfolie mit der Maskensuspension (Graphit in wäßriger Lösung) beschichtet und anschließend getrocknet. Nachfolgend wurde das Maskenmaterial aufgewickelt und entnommen, da die Anlage für die eigentliche Diffuserherstellung umgerüstet werden mußte. Zur Herstellung von Diffuseren wurde wiederum Polyesterfolie beschichtet, dieses Mal mit UV-strukturierbarem Photonanomer® und anschließend getrocknet. Im Anschluß hieran erfolgte die Laminierung von Maskenmaterial und Photonanomer®, bevor eine Strukturierung mit UV-Licht vonstatten ging. Nach der Belichtung wurden Maske und Diffuser wieder von einander getrennt (Delaminierung).

Die WO 2006/125635 A1 beschreibt ein Verfahren zur Herstellung regenerierbarer Platten mit strukturierbarer Oberfläche aus hydrophilen und hydrophoben Bereichen, welche sich hervorragend zum Herstellen von Mikrostrukturen durch Belichtung eignen. Diese Platten sind variabel und reversibel, können allerdings nicht in ein kontinuierliches Verfahren eingebunden werden, da es eben Platten sind. Bei der Belichtung kommt es somit zu Verweilzeiten, und nach einmaligem Einsatz müssen die Platten regeneriert werden.

Die Herstellung optischer Bauteile mit einer Gradientenstzuktur ist aus der EP 0 891 565 B1 bekannt.

Aus der EP 726 142 A2 ist ein System zur kontinuierlichen Laminierung und Entlaminicrung von Folien bekannt, das einen Folienzuführungsabschnitt zum Zuführen einer Folie aus photoempfindlichem Material, einem Folienlaminierungsabschnitt zum kontinuierlichen Laminieren der zugeführten Folie auf ein zu duplizierende Holograrnm-Originalplatte, die auf einer zylindrischen Oberfläche eines Zylinders fixiert ist, einer Andruckrolle, um die Folie in einen engen Kontakt mit der Originalplatte zu bringen, einem Folienentlaminierungsabschnitt zum kontinuierlichen Entlaminieren der Folie von der Originalplatte und einem Folienaufnahmeabschnitt zum Aufnehmen der entlaminierten Folie bekannt.

Aufgabe der Erfindung ist es, ein neues kontinuierliches Verfahren sowie eine neue Vorrichtung für die Herstellung von strukturierten optischen Materialien zu schaffen, das wirtschaftlicher als das bekannte Produktionsverfahren ist.

Diese Aufgabe wird bei einem Verfahren gemäß dem Oberbegriff von Anspruch 1 erfindungsgemäß dadurch gelöst, daß auf einen drehbaren Maskenzylinder aus transparentem Material, der gegen mindestens zwei Auflagewalzen gedrückt wird, ein Maskenmaterial aufgetragen wird, daß eine Strukturierung des optischen Materials in dem Bereich zwischen den Auflagewalzen erfolgt, und daß anschließend das strukturierte optische Material wieder von dem Maskcnzylinder delaminiert wird.

Diese Vorgehensweise ist wesentlich einfacher als bekannte Verfahren und damit auch kostengünstiger.

Im Rahmen der Erfindung wurde ein neuartiges, kontinuierliches und wirtschaftlich durchführbares Verfahren zur Herstellung von strukturierten optischen Materialien geschaffen, das die Maskenproduktion auf Folienbasis, wie sie beim Stand der Technik erfolgt, überflüssig werden läßt, und somit um ein Vielfaches wirtschaftlicher ist als das bisherige Produktionsverfahren. Hierbei steht ein Maskenzylinders, der gleichzeitig als Maske und als Förderorgan für die Folie fungiert, im Mittelpunkt.

Selbstverständlich kann das Maskenmaterial auch durch jedes andere Applikationsverfahren zum Auftragen von fluidischen Substanzen auf den Maskenzylinder aufgetragen werden.

Anschließend durchläuft das aus dem Maskenzylinder und dem Maskenmaterial bestehende Laminat eine Belichtung, bevor es die zweite Auflagewalze erreicht. Hinter dieser Auflagewalze liegt kein Anpreßdruck mehr vor und das strukturierte optische Material wird wieder von dem Maskenzylinder getrennt; es erfolgt die Delaminierung.

Mit diesem neuartigen kontinuierlichen Lithographieverfahren und der damit verbundenen Herstellung von Lichtmanagementfolien könnten strukturierte optische Materialien um ein Vielfaches wirtschaftlicher hergestellt werden. Durch das Entfallen der Maskenproduktion auf Folienbasis wird nicht nur ein erheblicher Zeitanteil eingespart, sondern auch etliche Material- und Herstellungskosten (Anlage, Personal, Betriebskosten, Materialkosten). Schätzungsweise halbiert sich der Zeitaufwand für die Herstellung von strukturierten optischen Materialien hierdurch. Mit Hilfe dieses Lithographieverfahrens wird zusätzlich der Herstellungsprozeß als solcher vereinfacht, da diese Vorrichtung keine separate Steuerung und Regelung benötigt. Daher entfallen steuer- und regeltechnische Maßnahmen für das Aufbringen, Belichtung und Delaminierung, welche bei dem bisherigen Verfahren notwendig sind und Probleme bereiten.

Eine Ausbildung der Erfindung besteht darin, daß Strahlung, insbesondere UV-, IR-, Wärme- oder Elektroneastrahlung oder Licht im sichtbaren Bereich, von einer der Stirnseiten des Maskenzylinders in dessen Hohlraum eingekoppelt und durch einen Spiegel im Hohlraum des Maskenzylinders in den Bereich zwischen den Auflagewalzen geleitet wird.

Alternativ könnte beispielsweise auch die Strahlungsquelle in dem Hohlraum des Zylinders angeordnet sein und auf den Bereich zwischen den Auflagewalzen gerichtet sein.

Eine vorteilhafte Ausgestaltung der Erfindung besteht darin, daß ein symmetrischer Spiegel, ein asymmetrischer Spiegel, ein schwenkbarer Spiegel, ein beweglicher und fest einstellbarer oder ein semipermeabler Spiegel zum Erzeugen von lokal unterschiedlichen optischen Eigenschaften verwendet wird.

Mit einem derartigen Spiegel können lokal unterschiedliche Profile in einem kontinuierlichen Herstellungsprozeß erzeugt werden, indem der Lichtstrahl umgelenkt wird. Dies ist beispielsweise für die Herstellung von Displays von Vorteil. Durch Kippen oder Schwenken des Spiegels kann ein asymmetrisches Profil der Strukturierung erreicht werden.

Überdies kann in ein holographisches Material ein Reflexions- und Transmissionshologramm eingebracht werden, indem im Rahmen einer Zweiwellenmischtechnik ein Laserstrahl oder eine andere geeignete Strahlungsquelle zunächst durch einen semipermeablen Spiegel aufgetrennt und durch ein geeignetes optisches Wegesystem, bestehend aus weiteren Spiegeln, wieder auf das Substrat fokussiert wird. Der Winkel zwischen beiden Strahlen bestimmt hierbei das entstehende holographische Interferenzbild gemäß der Bragg'schen Beziehung. Eine Mischung aus zwei verschiedenen Hologrammtypen ist beispielsweise für die Herstellung von Sicherheitsmerkmalen relevant.

Eine Weiterbildung der Erfindung besteht darin, daß die Strukturierung bei vorzugsweise 30 bis 70°C erfolgt.

Im Rahmen der Erfindung liegt auch eine Vorrichtung zum Herstellen von strukturierten optischen Materialien nach Anspruch 5, mit Mitteln zum Aufragen eines Maskenmaterials auf einen Träger, Mit teln zum Strukturieren des optischen Materials und Mitteln zum Delaminieren des Maskenmaterials von dem Träger, wobei ein drehbarer Maskenzylinder aus transparentem Material als Träger vorgesehen ist, daß Mittel zum Andrücken des Maskenzylinders gegen mindestens zwei Auflagewalzen vorgesehen sind und daß Mittel zum Einkoppeln von Strahlung in den Bereich zwischen den Auflagewalzen vorgesehen sind.

In diesem Zusammenhang ist es vorteilhaft, daß ein Maskenmaterial mittels Tauch-, Sprüh- oder Aufdampfbeschichtung auf den Maskenzylinder aufgetragen ist.

Bei diesem Maskenmaterial kann es sich beispielsweise um ein Hologramm handeln.

In diesem Zusammenhang hat es sich als vorteilhaft erwiesen, daß der Maskenzylinder aus Glas, vorzugsweise aus Quarzglas, besteht.

Weiterhin ist erfindungsgemäß vorgesehen, daß der Maskenzylinder mit modifiziertem NaSi beschichtet ist.

Im Rahmen der Strukturierung mittels Strahlung kann die Strukturierungsmaske des Maskenzylinders unter Verwendung von Graphit oder Pigmenten erfolgen. Es ist auch grundsätzlich möglich, das Maskenmaterial auf der Innenseite des Maskenzylinders aufzutragen.

Zur Erfindung gehörig ist ebenfalls, daß im Innern des Maskenzylinders angeordnete Gegendruckwalzen zum Andrücken des Maskenzylinders gegen die Auflagewalzen vorgesehen sind.

Eine Weiterbildung der Erfindung besteht darin, daß die Gegendruckwalzen gefedert sind.

Es ist vorteilhaft, daß die Auflagewalzen mit einer Gummierung versehen sind.

Zur Erfindung gehörig ist weiterhin, daß Strahlung von einer der Stirnseiten des Maskenzylinders in dessen Hohlraum einkoppelbar ist und daß im Hohlraum des Maskenzylinders ein Spiegel zum Leiten der Strahlung in den Bereich zwischen den Auflagewalzen vorgesehen ist.

Wie bereits oben ausgeführt, ist es vorteilhaft, daß der Spiegel ein symmetrischer Spiegel, ein asymmetrischer Spiegel, ein schwenkbarer Spiegel, ein beweglicher und fest einstellbarer oder ein semipermeabler Spiegel ist.

Dies ermöglicht es, nicht nur ein symmetrisches optisches Profil (durch senkrechten Strahlungseinfall) herzustellen, sondern auch asymmetrische optische Strukturierungen, bei denen die Strahlung in einem von der Senkrechte abweichenden Winkel auf das zu strukturierende Material fällt.

Schließlich ist es zwecksmäßig, daß im Bereich zwischen den beiden Auflagewalzen eine Wärmequelle zum Erwärmen des optischen Materials angeordnet ist.

Schließlich ist auch die Verwendung des erfindungsgemäßen Verfahrens (bzw. der erfindungsgemäßen Vorrichtung) zur Herstellung von Diffusern, insbesondere asymmetrischen Diffuseren, gemäß Anspruch 15 Gegenstand der Erfindung.

Nachfolgend wird ein Ausführungsbeispiel der Erfindung anhand von Zeichnungen näher erläutert.

Es zeigen
- Fig. 1: eine erfindungsgemäße Vorrichtung in Vorderansicht,
- Fig. 2: eine erfindungsgemäße Vorrichtung in Seitenansicht.

### Experimentelles

### 1.1. Vorbereitung

### 1.1.1 Beschichtungssystem

Das zu strukturierende System trägt die Bezeichnung Photonanomer®.

### 1.1.2 Maske

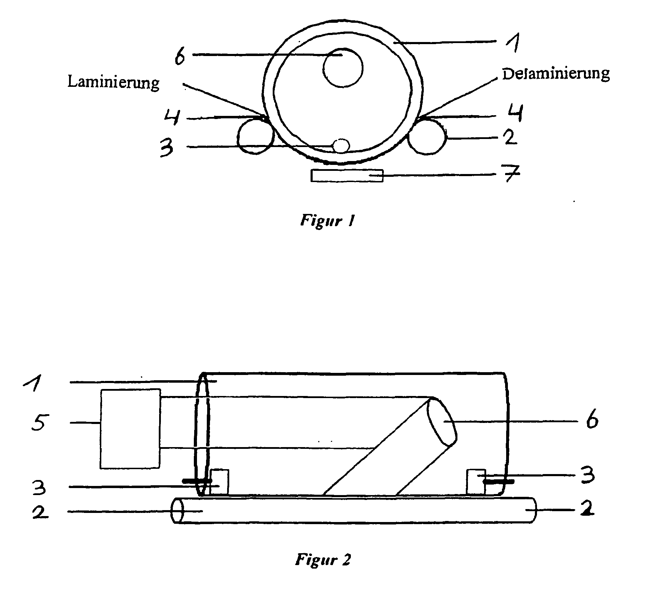

Die Figuren 1 und 2 zeigen den Maskenzylinder 1, bei dem es sich um einen Quarzglaszylinder (hier mit 5 mm Wandstärke, 0 300 mm) handelt. Dieser Quarzglaszylinder wird mit NaSi, das mit Graphitpartikeln modifiziert ist (NaSi + 1,5 Gew.-% KS 4 Graphit), tauchbeschichtet. Die Ziehgeschwindigkeit während der Beschichtung beträgt 2 mm/s. Aufgrund der Volumenverdrängung durch den Quatzglaszylinder entspricht dies einer Geschwindigkeit von 4 mm/s. Die Trocknung erfolgt wähnend 1 h bei 80°C im Trockenschrank. Eine anschließende Hochtemperaturprozedur bei 500°C (1 K/min, 1 h bei 500°C) diente zur Verdichtung der Maske.

Wie den Figuren 1 und 2 zu entnehmen ist, wird der Maskenzylinder 1 von einer Trägervorrichtung getragen. Diese Vorrichtung besteht aus einem Grundrahmen, auf dem zwei parallel zur Mittelachse des Maskenzylinders 1 und außerhalb desselben angeordnete, gelagerte Auflagewalzen 2 und zwei im Innern des Maskenzylinders angeordnete Gegendruckwalzen 3 montiert sind. Die Gegendruckwalzen 3 im Inneren des Maskenzylinders werden über Federn gespannt, so daß diese Gegendruckwalzen 3 den Maskenzylinder 1 gegen die auf der Außenseite des Maskenzylinders 1 befindlichen Auflagewalzen 2 drücken. Diese vier Walzen gewährleisten eine gleichmäßige Rotation des Maskenzylinders 1 und drücken diesen gegen die gummierten Auflagewalzen 2.

### 1.1.3 Substrat

Als Substratmaterial kommt beispielsweise Melinex Folie 400, eine Polyesterfolie, mit einer Stärke von 50 µm und einer Breite von 540 mm zum Einsatz. Diese Folie trägt auf der Außenseite eine Antiblock-Vorbehandlung. Die Beschichtung erfolgte auf der unbehandelten Innenseite der Substratfolie.

### 1.1.4 Bahnlauf

Der Bahnlauf läßt sich grob in drei Teilbereiche aufteilen:
a) Beschichtung
b) Trocknung
c) Belichtungseinheit

Im Teilbereich a findet das Auftragen des Photonanomers® statt, hierzu wird ein Rakelprozeß verwendet. Bereich B umfaßt die Trocknung der Schichten mit Umluft und im letzten der drei Teilbereiche kommt es schließlich zur Strukturierung mit UV Licht.

Nähere Erläuterungen zu den einzelnen Bereichen sind unter Punkt 1.2 zu finden.

### 1.2. Durchführung

### 1.2.1 Beschichtung

### 1.2.1.1 Abwicklung & Masterwalze

Die Positionen der nachfolgenden Tabelle geben die Parameter für die Abwicklung und Masterwalze, mit der die Bahngeschwindigkeit gesteuert wird, wieder.

| Nr. | Name | Wert |
|---|---|---|
| 1 | Beschichtete Folienseite | Innen |
| 2 | Druck der Bremse Abwic kler | 1 bar |
| 3 | Leistung Korona | Aus |
| 4 | Ionisierstab ja/nein | Aus |
| 5 | Druck der Andruckwalze | Aus |
| 6 | Bahngeschwindigkeit | 0,2 m/min |

Wichtige Prozeßparameter sind in dieser Tabelle die Punkte 2 und 6. Position 2 beschreibt den Druck der Bremse, der für eine ausreichende Bahnspannung verantwortlich ist Wird dieser Parameter falsch gewählt, kommt es zum Auslaufen des Rakelkastens. Unter Position 6 ist die Geschwindigkeit der Folienbahn zu finden, welche über die Masterwalze gesteuert wird. Diese wurde für diesen ersten Versuchslauf mit 0,2 m/min extrem langsam gewählt, um den gesamten Prozeß genau verfolgen und studieren zu können. Höhere Bahngeschwindigkeiten sind jedoch problemlos erreichbar.

### 1.2.1.2 Rakel

In der nachfolgenden Tabelle sind die Rakelparameter aufgelistet.

| Nr. | Name | Wert |
|---|---|---|
| 7 | Verwendetes Rakelmesser | Neu |
| 8 | Spalt Rakelmesser | 175 µm |
| 9 | Verwendeter Rakelkasten (Breite) | 6,5cm |
| 10 | Spalt Rakelkasten | 1 mm |
| 11 | Einfüllmethode | Manuell |
| 12 | Eingesetzte Lackmenge | 200ml |

Diese Tabelle zeigt die Beschichtungsparameter für den Rakelprozeß. Im Allgemeinen sind alle Angaben variabel und vom gewünschten Endergebnis abhängig. So kann der Rakelabstand (Position 8) je nach gewünschter Schichtdicke variieren, ebenso die Beschichtungsbreite (9) und die eingesetzte Lackmenge (12). Auch eine automatische Einfüllmethode ist denkbar, für diese Vorversuche aber nicht angebracht. Eine sehr schmale Beschichtungsbreite wurde gewählt, um den Prozeß zunächst einmal gut führen zu können.

### 1.2.2 Trocknung

### 1.2.2.1 Ofen

Nach der Beschichtung folgt das Trocknen der Schicht. Mit diesem Prozeßschritt wird das Lösemittel entfernt. Die nachfolgende Tabelle zeigt die Trocknungsparameter.

| Nr. | Name | Wert |
|---|---|---|
| 13 | Ofenklappe 1 | 9 |
| 14 | Ofenklappe 2 | 8 |
| 15 | Ofenklappe 3 | 8 |
| 16 | Ofenklappe 4 | 7 |
| 17 | Ofentemperatur | 80°C |
| 18 | Umluftgeschwindigkeit | 6,3 m/s |

Die in dieser Tabelle aufgeführten Ofenklappen (Position 13-16) regulieren die Strömung der Umluft innerhalb des Ofens. Zwei der Klappen sind für die Luftansaugung zuständig, die anderen beiden zur Luftverteilung. Je nach Ofengerät variieren diese Parameter, ebenso die Trocknungstemperatur. Eine Trocknungstemperatur von 80°C ist optimal für das verwendete Photonanomersystem, bei anderen Systemen muß die Temperatur entsprechend angepaßt werden. Die Umluftgeschwindigkeit wurde hier nur zur Vollständigkeit aufgerührt, sie ist aber kein essentieller Prozeßparameter.

### 1.23 Belichtungseinkeit

Von zentraler Bedeutung für den gesamten Prozeß ist die Trägervorrichtung mit zugehöriger Zylindermaske und die damit verbundene Belichtung. Diese essentiellen Bauteile werden nun näher erläutert.

### 1.2.3.1 Laminierung und Delaminierung ,

Die Figuren 1 und 2 zeigen den Aufbau der Belichtungseinheit mit dem Maskenzylinder 1. Ebenso sind Laminierung und Delaminierung in dieser Einheit integriert.

Die Strukturierung der beschichteten Folien 4 findet im Bereich zwischen den beiden Auflagewalzen 2 statt. Zusätzlich dienen die Auflagewalzen 2 als Führung bei der Laminierung. Das heißt: Aufgrund des Eigengewichtes und der Gegendruckwalzen liegt der Maskenzylinder 1 formschlüssig auf den beiden gummierten Auflagewalzen 2 auf Tritt nun die beschichtete Folie 4 (Beschichtung in Richtung Maskenzylinder gewandt) zwischen der ersten Auflagenwalze 2 und den Maskenzyünder 1 ein, wird sie aufgrund des gegenseitigen Druckes der beiden Elemente auf die Oberfläche des Maskenzylinder 1, sprich die Maske, auflaminiert. Zusätzlich sorgen die gummierten Auflagewalzen für eine blasenfreie Laminierung, welche unumgänglich bei der Herstellung von optischen Bauelementen ist. Nach der Laminierung durchläuft das Laminat Maskenzylinder-beschichtete Folie 4 eine Belichtung mit ultraviolettem Licht, bevor es die zweite Auflagewalze 2 erreicht. Hinter dieser Auflagewalze 2 wird der Druck durch die Zylinderrotation von der Auflagewalze 2 und somit auch von der Folie 4 genommen, und Makenzylinder 1 und Folie 4 werden wieder getrennt, es kommt zur Delaminierung.

Aufgrund seines Eigengewichtes, der Gegendruckwalzen 3 und der auflaminierten Folie 4 rotiert der Maskenzylinder 1 mit derselben Geschwindigkeit, mit der sich die Folie 4 fortbewegt. Daher ist keine zusätzliche Steuerung des Maskenzylinders sowie der Laminierung und Delaminierung erforderlich. Dieser Teil des Prozesses ist somit eine autonome Einheit die keiner separaten Regelung bedarf.

### 1.2.3.2 Strukturierung durch UV

Die Figuren 1 und 2 zeigen auch den Aufbau der Belichtungseinheit mit dem Maskenzylinder 1.

Wie bereits erwähnt, findet die Strukturierung zwischen den beiden gummierten Auflagewalzen 2 des Maskensystems statt. Das ultraviolette Licht wird von einer UV-Lichtquelle 5 an einer der Stirnseiten des Maskenzylinders 1 in dessen Hohlraum eingekoppelt. Ein Spiegel 6 (ausgelegt für die Wellenlänge des UV-Lichtes), der sich ebenfalls im Inneren des Maskenzylinders 1 befindet, lenkt das UV-Licht in den Bereich des Maskenzylinders 1, wo dieser zwischen den beiden Auflagewalzen 2 aufliegt. Die Maske und die beschichtete Folie 4 werden belichtet; der zugehörige Strukturierungsmechanismus ist bekannt. Unter der Folie 4 wird zusätzlich eine Wärmequelle 7 installiert. Diese soll die Folienbahn während des Belichtens auf 30 bis 70°C, vorzugsweise ca. 50°C, aufheizen, um den erwünschten Strukturierungsprozeß zu ermöglichen. Im vorliegenden Fall ist diese Wärmequelle ein konventioneller Heißluftfön. Mittels eines Temperatursensors wurde die Heißluft auf die gewünschte Temperatur eingestellt.

In der nachfolgenden Tabelle sind noch einmal die Prozeßparameter für die Strukturierung zusammengefaßt.

| Nr. | Name | Wert |
|---|---|---|
| 19 | Temperatur | 50°C |
| 20 | Wellenlänge | 365 nm |
| 21 | Beleuchtungsstärke | 126W/m² |
| 22 | Leistungseinstellung der Lampe | 1000 W |

### 1. Ergebnisse

Mit dieser Vorrichtung ist somit die Herstellung von strukturierten Beschichtungen (Diffuseren) möglich. Die entwickelte Vorrichtung vereint drei elementare Bereiche des Diffuser-Herstellungsprozesses, nämlich die Laminierung, die Belichtung (Strukturierung) und die Delaminierung. Weiterhin wird der Prozeß dahin gehend vereinfacht, daß die Vorrichtung keine eigenständige Steuerung und Regelung benötigt.

## Patentansprüche

1. Verfahren zum Herstellen von strukturierten optischen Materialien, **dadurch gekennzeichnet, daß** auf einen drehbaren Maskenzylinder (1) aus transparentem Material, der gegen mindestens zwei Auflagewalzen (2) gedrückt wird, optisches Material (4) aufgetragen wird, daß eine Strukturierung des optischen Materials (4) in dem Bereich zwischen den Auflagewalzen (2) erfolgt, und daß anschließend das strukturierte optische Material (4) von dem Maskenzylinder (1) delaminiert wird.

2. Verfahren gemäß Anspruch 1, **dadurch gekennzeichnet, daß** zur Strukturierung des optischen Materials (4) Strahlung, insbesondere UV-, IR-, Wärme- oder Elektronenstrahlung oder Licht im sichtbaren Bereich, von einer der Stirnseiten des Maskenzylinders (1) in dessen Hohlraum eingekoppelt und durch einen Spiegel (6) im Hohlraum des Maskenzylinders (1) in den Bereich zwischen den Auflagewalzen (2) geleitet wird.

3. Verfahren gemäß Anspruch 2, **dadurch gekennzeichnet, daß** ein symmetrischer Spiegel (6), ein asymmetrischer Spiegel (6), ein schwenkbarer Spiegel (6), ein beweglicher und fest einstellbarer oder ein semipermeabler Spiegel (6) zum Erzeugen von lokal unterschiedlichen optischen Eigenschaften verwendet wird.

4. Verfahren gemäß Anspruch 1, **dadurch gekennzeichnet, daß** die Strukturierung bei vorzugsweise 30 bis 70°C erfolgt.

5. Vorrichtung zum Herstellen von strukturierten optischen Materialien, mit Mitteln zum Auftragen eines optischen Materials (4) auf einen Träger, Mitteln zum Strukturieren des optischen Materials (4) und Mitteln zum Delaminieren des optischen Materials (4) von dem Träger, **dadurch gekennzeichnet, daß** ein drehbarer Maskenzylinder (1) aus transparentem Material als Träger vorgesehen ist, daß Mittel (3) zum Andrücken des Maskenzylinders (1) gegen mindestens zwei Auflagewalzen (2) vorgesehen sind und daß Mittel (5) zum Einkoppeln von Strahlung in den Bereich zwischen den Auflagewalzen (2) vorgesehen sind.

6. Vorrichtung gemäß Anspruch 5, **dadurch gekennzeichnet, daß** ein Maskenmaterial mittels Tauch-, Sprüh- oder Aufdampfbeschichtung auf den Maskenzylinder (1) aufgetragen ist.

7. Vorrichtung gemäß Anspruch 5, **dadurch gekennzeichnet, daß** der Maskenzylinder (1) aus Glas, vorzugsweise aus Quarzglas, besteht.

8. Vorrichtung gemäß Anspruch 5 oder Anspruch 6, **dadurch gekennzeichnet, daß** der Maskenzylinder (1) mit mittels Graphitpartikeln modifiziertem NaSi beschichtet ist.

9. Vorrichtung gemäß Anspruch 5, **dadurch gekennzeichnet, daß** im Innern des Maskenzylinders (1) angeordnete Gegendruckwalzen (3) zum Andrücken des Maskenzylinders (1) gegen die Auflagewalzen (2) vorgesehen sind.

10. Vorrichtung gemäß Anspruch 9, **dadurch gekennzeichnet, daß** die Gegendruckwalzen (3) gefedert sind.

11. Vorrichtung gemäß Anspruch 9, **dadurch gekennzeichnet, daß** die Auflagewalzen (2) mit einer Gummierung versehen sind.

12. Vorrichtung gemäß Anspruch 5, **dadurch gekennzeichnet, daß** Strahlung von einer der Stirnseiten des Maskenzylinders (1) in dessen Hohlraum einkoppelbar ist und daß im Hohlraum des Maskenzylinders (1) ein Spiegel (6) zum Leiten der Strahlung in den Bereich zwischen den Auflagewalzen (2) vorgesehen ist.

13. Vorrichtung gemäß Anspruch 12, **dadurch gekennzeichnet, daß** der Spiegel (6) ein symmetrischer Spiegel (6), ein asymmetrischer Spiegel (6), ein schwenkbarer Spiegel (6), ein beweglicher und fest einstellbarer oder ein semipermeabler Spiegel (6) ist.

14. Vorrichtung gemäß Anspruch 5, **dadurch gekennzeichnet, daß** im Bereich zwischen den beiden Auflagewalzen (2) eine Wärmequelle (7) zum Erwärmen des optischen Materials (4) angeordnet ist.

15. Verwendung des Verfahrens gemäß den Ansprüchen 1 bis 4 zur Herstellung von Diffusern, insbesondere von Diffusern mit einem lokal unterschiedlichen Profil.

## Claims

1. Method for producing structured optical materials, **characterised in that** optical material (4) is applied to a transparent rotatable mask cylinder (1) that is pressed against at least two bearing rollers (2), that structuring of the optical material (4) is performed in the section between the bearing rollers (2), and that the structured optical material (4) is subsequently delaminated from the mask cylinder (1).

2. Method according to claim 1, **characterised in that** for the purpose of structuring the optical material (4), radiation, in particular UV, IR, thermal or electron radiation or light in the visible range, is coupled from one end of the mask cylinder (1) into its hollow interior and is directed by a mirror (6) located in the hollow interior of the mask cylinder (1) onto the section between the bearing rollers (2).

3. Method according to claim 2, **characterised in that** a symmetric mirror (6), an asymmetric mirror (6), a slewable mirror (6), a movable mirror that can be preset or a semi-permeable mirror (6) is used to produce optical properties with localised variations.

4. Method according to claim 1, **characterised in that** structuring is performed at preferably 30 to 70 °C.

5. Device for producing structured optical materials, said device featuring means for applying an optical material (4) to a carrier, means for structuring the optical material (4) and means for delaminating the optical material (4) from the carrier, **characterised in that** a transparent rotatable mask cylinder (1) is provided as carrier, that means (3) are provided for pressing the mask cylinder (1) against at least two bearing rollers (2), and that means (5) are provided for coupling radiation into the section between the bearing rollers (2).

6. Device according to claim 5, **characterised in that** a mask material is applied to the mask cylinder (1) by means of dip-coating, spray-coating or vapour coating.

7. Device according to claim 5, **characterised in that** the mask cylinder (1) consists of glass, preferably of quartz glass.

8. Device according to claim 5 or claim 6, **characterised in that** the mask cylinder (1) is coated with NaSi modified with graphite particles.

9. Device according to claim 5, **characterised in that** counterpressure rollers (3) for pressing the mask cylinder (1) against the bearing rollers (2) are provided in the interior of the mask cylinder (1).

10. Device according to claim 9, **characterised in that** the counterpressure rollers (3) are spring-mounted.

11. Device according to claim 9, **characterised in that** the bearing rollers (2) are provided with a rubber coating.

12. Device according to claim 5, **characterised in that** radiation can be coupled from one end of the mask cylinder (1) into the interior thereof and that a mirror (6) for directing the radiation onto the section between the bearing rollers (2) is provided in the hollow interior of the mask cylinder (1).

13. Device according to claim 12, **characterised in that** the mirror (6) is a symmetric mirror (6), an asymmetric mirror (6), a slewable mirror (6), a movable mirror that can be preset or a semi-permeable mirror (6).

14. Device according to claim 5, **characterised in that** a heat source (7) for warming the optical material (4) is located in the area between the two bearing rollers (2).

15. Use of the method according to the claims 1 to 4 for producing diffusers, in particular diffusers with profiles showing localised variations.

## Revendications

1. Procédé pour la fabrication de matériaux optiques structurés, **caractérisé en ce qu'**un matériau optique (4) est déposé sur un cylindre de masquage (1) rotatif, qui est réalisé dans un matériau transparent et qui est pressé contre au moins deux cylindres d'appui (2), **en ce qu'**une structuration du matériau optique (4) est réalisée dans la zone située entre les cylindres d'application (2), et **en ce que**, ensuite, le matériau optique structuré (4) est délaminé du cylindre de masquage (1).

2. Procédé selon la revendication 1, **caractérisé en ce que**, pour la structuration du matériau optique (4), un rayonnement, en particulier un rayonnement UV, IR, thermique ou électronique ou une lumière dans le domaine visible, est injecté par l'une des faces frontales du cylindre de masquage (1) dans la cavité de celui-ci et est dirigé dans la cavité du cylindre de masquage (1) dans la zone située entre les cylindres d'appui (2) par un miroir (6).

3. Procédé selon la revendication 2, **caractérisé en ce qu'**un miroir (6) symétrique, un miroir (6) asymétrique, un miroir (6) pivotant, un miroir (6) mobile et réglable de manière fixe ou un miroir (6) semi-perméable est utilisé pour générer des propriétés optiques localement différentes.

4. Procédé selon la revendication 1, **caractérisé en ce que** la structuration est réalisée de préférence entre 30 et 70°C.

5. Dispositif pour la fabrication de matériaux optiques structurés, comportant des moyens pour appliquer un matériau optique (4) sur un support, des moyens pour structurer le matériau optique (4) et des moyens pour délaminer le matériau optique (4) du support, **caractérisé en ce que** le support prévu est un cylindre de masquage (1) rotatif réalisé dans un matériau transparent, **en ce qu'**il est prévu des moyens (3) pour presser le cylindre de masquage (1) contre au moins deux cylindres d'appui (2) et **en ce que** des moyens (5) sont prévus pour injecter un rayonnement dans la zone située entre les cylindres d'appui (2).

6. Dispositif selon la revendication 5, **caractérisé en ce qu'**un matériau de masquage est déposé sur le cylindre de masquage (1) au moyen d'un processus de revêtement par immersion, par pulvérisation ou par dépôt sous vide.

7. Dispositif selon la revendication 5, **caractérisé en ce que** le cylindre de masquage (1) est réalisé en verre, en particulier en verre de quartz.

8. Dispositif selon la revendication 5 ou la revendication 6, **caractérisé en ce que** le cylindre de masquage (1) est revêtu de NaSi modifié au moyen de particules de graphite.

9. Dispositif selon la revendication 5, **caractérisé en ce que** des cylindres de contre-pression (3) sont prévus à l'intérieur du cylindre de masquage (1) en vue de presser le cylindre de masquage (1) contre les cylindres d'appui (2).

10. Dispositif selon la revendication 9, **caractérisé en ce que** les cylindres de contre-pression (3) sont montés sur ressorts.

11. Dispositif selon la revendication 9, **caractérisé en ce que** les cylindres d'appui (2) sont munis d'un revêtement en caoutchouc.

12. Dispositif selon la revendication 5, **caractérisé en ce qu'**un rayonnement peut être injecté depuis l'une des faces frontales du cylindre de masquage (1) dans la cavité de celui-ci, et **en ce que** dans la cavité du cylindre de masquage (1) est prévu un miroir (6) pour guider le rayonnement dans la zone située entre les cylindres d'appui (2).

13. Dispositif selon la revendication 12, **caractérisé en ce que** le miroir (6) est un miroir (6) symétrique, un miroir (6) asymétrique, un miroir (6) pivotant, un miroir (6) mobile et réglable de manière fixe ou un miroir (6) semi-perméable.

14. Dispositif selon la revendication 5, **caractérisé en ce qu'**une source de chaleur (7), destinée à chauffer le matériau optique (4), est disposée dans la zone située entre les deux cylindres d'appui (2).

15. Utilisation du procédé selon l'une des revendications 1 à 4 pour la fabrication de diffuseurs, en particulier des diffuseurs avec un profil localement différent.
